(19) **Europäisches Patentamt**
**European Patent Office**
**Office européen des brevets**

(11) **EP 3 160 054 A1**

(12) **EUROPEAN PATENT APPLICATION**

(43) Date of publication:
**26.04.2017 Bulletin 2017/17**

(51) Int Cl.:
**H04B 7/02** (2017.01)   **H04W 52/14** (2009.01)
**H04W 52/38** (2009.01)   **H04W 52/40** (2009.01)

(21) Application number: **15306703.8**

(22) Date of filing: **23.10.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(71) Applicant: **ALCATEL LUCENT**
**92100 Boulogne-Billancourt (FR)**

(72) Inventors:
• **FANG, Dong**
**15 Dublin (IE)**

• **KUCERA, Stepan**
**15 Dublin (IE)**
• **CLAUSSEN, Holger**
**15 Dublin (IE)**

(74) Representative: **Mills, Julia et al**
**Script IP Limited**
**18 Bridge Street**
**Frome Somerset BA11 1BB (GB)**

Remarks:
Amended claims in accordance with Rule 137(2) EPC.

(54) **A WIRELESS COMMUNICATION NETWORK HAVING COORDINATED MULTIPLE BASE STATIONS**

(57) A wireless communicaton network comprises a plurality of coordinated network nodes (20). At each network node a combined encoded signal is received and sent to a decoder (22), the combined encoded signal comprises a combination of a plurality of encoded user equipment messages received at the network node, each user equipment message being transmitted from a respective one of a plurality of user equipment (50) and each being encoded using a same lattice code (52) to form codewords from a same codebook. The combined encoded signal is decoded using a same codebook as is used to encode the signals and a decoded combined signal is generated which comprises an integer combination of the user equipment messages.

FIG. 3

**Description**

FIELD OF THE INVENTION

The field of the invention relates to wireless telecommunication systems and in particular to systems having multiple base stations that act in a coordinated manner and the encoding and decoding of uplink data in such a system.

BACKGROUND

Wireless telecommunication systems are known. In such systems user equipment including network connectable or mobile communication devices such as, mobile telephones and similar communicate with base stations provided by network providers.

In known wireless telecommunication systems, radio coverage is provided to network connectable devices within areas known as cells. A base station is located in each cell to provide radio coverage. Typically, network connectable devices in each cell are operable to receive information and data from a base station and to transmit information and data to a base station. Network connectable devices roam through a wireless communication system. A number of base stations are provided and are distributed geographically in order to provide a wide area of coverage to network connectable devices.

The amount of data traffic transmitted using wireless communication is increasing. The 3GPP standardization for fifth generation (5G) networks for mobile communication targets unprecedented capacity densities of up to 25 Gbit/s/km$^2$. One way of achieving such goals is by reducing cell sizes, i.e. by deploying small cells such as picocells and metrocells. This approach, however, requires larger numbers of base stations (BS) which is challenging in terms of backhaul and power provisioning as well as site rental costs.

Other capacity-improving techniques are being investigated, most notably coordinated multipoint (CoMP) techniques (also known as network MIMO). In CoMP, several BSs actively cooperate to serve multiple user equipment (UE) similarly to a large multi-user distributed MIMO system. For example, BSs engage in coordinated scheduling of downlink transmissions or joint processing of uplink signals. The combination of a large number of antennas results in a significantly increased multiplexing gain - UEs can operate with the same radio resources without causing mutual interference which greatly increases capacity of cellular systems.

However, CoMP techniques potentially increase the backhaul load: on the uplink, the (compressed) signals received by each BS must be forwarded to the combining point, e.g. central unit. This is especially a problem for wireless backhaul systems, and 5G radio access networks (RAN) with centralized processing, requiring dense small-cell deployments.

It would be desirable to increase the capacity for wireless uplink transmission without unduly increasing backhaul loads or processing requirements at individual base stations.

SUMMARY

A first aspect provides a method performed at a network node configured to operate in a coordinated multiple network node system, said method comprising: receiving a combined encoded signal, said combined encoded signal comprising a combination of a plurality of encoded user equipment messages, each user equipment message being transmitted from a respective one of a plurality of user equipment and each being encoded using a lattice code to form codewords from a same codebook; decoding said combined encoded signal using said same codebook to generate a decoded combined signal; and outputting said decoded combined signal.

The use of coordinated base stations to enhance coverage where single base stations are replaced with multiple base stations and a central control unit or central network control node receives signals from each base station and forwards them as required is known. The central unit also controls the communications to reduce interference between signals. Although this can provide increased capacity it also can lead to a significant increase in backhaul traffic where the base stations need to communicate data received from user equipment with the centralised unit that coordinates communications

The inventors of the present invention recognised that data encoded with certain coding schemes in particular lattice coding has certain properties. In particular, an integer sum of data encoded using a lattice encoder will form a valid codeword from the same codebook. As signals received from multiple user equipment at an antenna of a base station will be a sum of each signal or message, were such signals to be encoded using the same lattice coding, then the sum of these signals were they to have integer coefficients, would be a codeword from this lattice coding and such a combined signal could be decoded using a lattice decoder corresponding to the lattice encoders without the need to separate the combined signals prior to decoding.

Although such a combined encoded signal received at a base station may not in many cases be an exact integer sum of the individual codewords, such a signal can be viewed as a sum of integer coefficients of each encoded message plus a sum of fractional coefficients of the encoded messages, the fractional portions behaving like noise when decoding occurs.

The fact that the integer sum of such encoded signals is itself a codeword in the codebook means that the combined signal can be decoded as an individual signal using a decoder corresponding to the user equipment encoders without the need to demultiplex the signal and identify the individual user equipment messages. The decoded combined signal which corresponds to an integer sum of the user equipment messages can then be output. In this way with low processing requirements at the base station a decoded signal that corresponds to an integer sum of the user equipment messages can be retrieved and output. This signal can be transmitted to the central network control node with a low bandwidth thereby improving the spectral efficiency when compared to retrieving and transmitting each individual user equipment message.

In some embodiments, said lattice code comprises a low density lattice code.

Although any lattice coding or indeed any coding, which has the properties that an integer sum of encoded signals will also form a codeword within the codebook of the encoder could be used to decode the combined signal, it has been found that low-density lattice coding is a particularly effective code for wireless communications as it achieves high capacity allowing signals to be transmitted with the required rate and decoded with low errors.

In some embodiments, the method comprises a further step of: receiving a plurality of power weighting factors corresponding to said plurality of user equipment; and transmitting to each of said user equipment, an indicator of transmission power to be used by said user equipment when transmitting signals towards said network node, said indicator of transmission power being based on said received power weighting factors.

As noted previously, a combined encoded message which is an integer sum of the codewords sent from each user equipment forms a codeword in the same codebook and can therefore be decoded using a decoder corresponding to the encoders of the user equipment. Any fractional coefficients of the codewords received from the user equipment can be viewed as noise and will reduce the efficiency of the decoding. Thus, in order to decrease error rates it may be advantageous if the coefficients are manipulated to tend them towards integer numbers. In this regard, the weighting or coefficient of each user equipment message in the combined signal will depend on the power that the user equipment transmits that message with. Transmitting power indicators to each user equipment can be used to adjust the power level at which the individual codewords are received at the base station and thus, the coefficients of each codeword within the combined signal. Careful choice of such power weighting factors can provide a combined signal which has integer or near integer coefficients for each encoded user equipment messages.

The selection of the power weighting factors can also be made with a view to reduce other co-channel interference between the user equipment. This analysis and selection may be done by a central unit aware of the different user equipment and different base stations and the base station will simply receive a plurality of power weighting factors that corresponds to the plurality of user equipment for which it receives signals and it will transmit power transmission indicators to each of the user equipment allowing the user equipment to adjust their transmission power.

In some embodiments, the method further comprises receiving a scaling factor vector and performing a further step of rounding said combined encoded signal prior to decoding by multiplying said combined encoded signal by said scaling factor vector.

A further way of reducing errors in the decoding is by the use of a scaling factor which can be used to help round any fractional coefficients to integer numbers and again reduce the noise generated at decoding by fractional coefficients of the encoded individual messages. Again, such scaling factors can be determined centrally at the central control node and the base station will receive such signals and will multiply the combined encoded signal by the factor prior to decoding.

In some embodiments, said plurality of encoded user equipment messages are received at an antenna, and said combined encoded signal comprises a sum of said plurality of encoded user equipment messages.

The present technique is performed at a network node and the encoded user equipment messages are received there at an antenna. The antenna will act to combine the encoded messages to produce a sum of the plurality of encoded user equipment messages. This property of an antenna makes the use of lattice codes for encoding user equipment messages particularly effective in a coordinated multiple network node system. As the signal output by the antenna is the sum of many different signals, in order to decode such a signal at a network node without identifying the individual components of the signal, an encoding system with the property that the integer sum of the encoded messages is also a codeword in the codebook is helpful. Such an encoding system enables a combined signal to be decoded without the need to separate out the component parts, thereby reducing the processing requirements at the network nodes.

In some embodiments, said decoder comprises a serial decoder operable to decode a serial input stream to form a serial output stream.

A further advantage of embodiments of the technique is that it allows the decoder at the network node to be a serial decoder with a single input and single output such that the combined encoded signal is transmitted to the decoder without a requirement to demultiplex it into individuals signals first and this combined signal is decoded using the properties of lattice codes and a serial decoded stream corresponding to an integer sum of the individual user equipment messages is output to the backhaul link for transmission to the central node. This reduces processing complexity and also provides a low bandwidth signal for transmission to the central control node.

A second aspect of the present invention provides a network node configured to operate in a coordinated multiple network node system, said network node comprising: an antenna configured to receive encoded user equipment messages from a plurality of user equipment, and to output a combined encoded signal, comprising a combination of said plurality of encoded user equipment messages each of said plurality of user equipment messages being encoded using a same lattice code with a same codebook; decoding logic operable to decode said combined encoded signal using said same lattice codebook and to output a combined decoded signal to a port for connection to a backhaul link.

In some embodiments, said port is operable to receive a plurality of power weighting factors corresponding to said plurality of user equipment; and said network node comprises a transmitter operable to transmit indications of power to be applied by said user equipment when transmitting signals towards said network node, said indicators of transmission power being based on said received power weighting factors.

In some embodiments, said receiver is further operable to receive a scaling factor vector, said network node comprising rounding logic operable to perform rounding of said combined encoded signal, prior to decoding by multiplying said combined encoded signal by said scaling factor vector.

In some embodiments, said decoder comprises a serial decoder operable to receive and decode a serial input stream to form a serial output stream.

A third aspect of the present invention provides a method performed at a central network control node, said method comprising: receiving a combined decoded signal from each of a plurality of network nodes, each of said plurality of received combined decoded signals comprising an integer combination of a plurality of user equipment messages from a plurality of user equipment; and solving a set of linear equations formed by said integer combination of user equipment messages to determine each user equipment message.

In a co-ordinated multiple network node network, then a central network control node or central unit is provided which receives signals from the network nodes and provides centralised control of the operation of the network and distributes the signals between the network nodes for transmission to the user equipment as required. In this technique, the signals received at the network control node from each network node correspond to an integer combination of the plurality of user equipment messages that were received in encoded form at the respective network node. The network control node can solve a set of linear equations formed by these integer combinations and can resolve them to determine each user equipment message. In this way, although each individual network node may transmit a sum of user equipment messages, as these are an integer sum and as the network control node is aware of the properties of the system, these integer sums can be resolved and the individual user equipment messages can be retrieved.

In some embodiments, the method further comprises generating a plurality of power weighting factors for transmission to each of said plurality of network nodes, each of said plurality of network nodes receiving signals from said plurality of user equipment, and each of said plurality of power weighting factors being indicative of a transmission power to be used by a respective one of said plurality of user equipment; wherein said power weighting factors are generated following analysis of said user equipment and network nodes and are selected to reduce co-channel interference between user equipment.

In addition to resolving the combined decoded signals received from each network node, the central network control node may generate power weighting factors to be sent to each network node, each power weighting factor corresponding to a user equipment that the network node receives signals from. The network node can then forward such information to the user equipment and this controls the power transmission that the user equipment transmits messages at. The central network control node can provide central control and by analysing the user equipment and network nodes and the channels they communicate on can select suitable power weighting factors to reduce co-channel interference between user equipment.

In some embodiments, said power weighting factors are selected to seek to provide an integer combination of user equipment messages in a combined encoded user equipment signal received at each network node by reducing fractional coefficients of encoded user equipment messages in said combined encoded signal.

These weighting factors may reduce co-channel interference by selecting power weighting factors that seek to reduce fractional coefficients of encoded user equipment messages received in the combined encoded signal at the network node, such that this combined encoded signal is an integer or near integer combination of the user equipment messages. As noted previously, any fractional coefficients will be seen as noise by the decoder and will reduce the decoding efficiency. The recognition that the coefficients of the individual encoded user equipment signals that are received at each network node are dependent on the power that that signal is transmitted at, allows these coefficients to be controlled by varying that power. Thus, the control network node which may receive information from each base station about each user equipment and their channel strength can provide control of this power to reduce fractional coefficients and thereby improve the efficiency of the decoder.

In some embodiments, the method comprises generating a coordination matrix comprising a plurality of scaling factor vectors corresponding to said plurality of network nodes, said scaling factor vectors comprising scaling factors to reduce noise in a combined encoded signal received at each network node from a plurality of user equipment by rounding coefficients of encoded user equipment messages and thereby reducing a fractional portion of said coefficients in said combined encoded signal.

A further way of reducing the fractional coefficients of the encoded user equipment messages is by the use of scale factor vectors which simply scale the signals by a certain amount. A vector is required as the signals will be complex signals. Thus, by further analysis of the system, the centralised network control node can generate scaling factor vectors which can further reduce fractional coefficients.

A fourth aspect of the present invention provides a central network control node comprising: a receiver operable to receive a combined decoded signal from each of a plurality of network nodes, each of said plurality of received combined decoded signals comprising an integer combination of a plurality of user equipment messages, said method comprising: solving a set of linear equations formed by said integer combination of user equipment messages to determine each user equipment message.

In some embodiments, said network control node comprises a power weighting factor generator operable to analyse said user equipment and network nodes and to generate power weighting factors for each of a plurality of user equipment, said power weighting factors being generated to reduce co-channel interference between said plurality of user equipment; and an output operable to output said plurality of power weighting factors to each of the plurality of network nodes.

In some embodiments, said power weighting factor generator is operable to select said power weighting factors so as to seek to provide an integer combination of user equipment messages in a combined encoded user equipment signal, by reducing fractional coefficients of encoded user equipment messages in said combined encoded signal.

In some embodiments, said network control node further comprises a coordination matrix generator, said coordination matrix generator being configured to generate a coordination matrix comprising a plurality of scaling factor vectors corresponding to said plurality of network nodes, said scaling factor vectors comprising scaling factors to reduce noise in a combined encoded signal received at each network node from a plurality of user equipment by reducing fractional coefficients of encoded user equipment messages in said combined encoded signal; and an output to output said plurality of scaling factor vectors to each of said plurality of network nodes.

A fifth aspect of the present invention provides a method performed at a user equipment comprising: receiving a broadcast signal comprising a plurality of power indicators for a plurality of user equipment; identifying said power indicator corresponding to said user equipment; encoding a user equipment message using a lattice encoder; transmitting said encoded user equipment message at a power indicated by said power indicator.

The present system provides a plurality of network nodes each receiving signals from a plurality of user equipment, all under the control of a centralised network control node. The individual user equipment transmit encoded messages encoded using a lattice encoder. In order to enhance the cooperation and reduce interference, the power of the transmissions by the user equipment may be controlled and thus, power indicators are transmitted from the base stations to the plurality of user equipment. As these indicators are to a plurality of user equipment, they are transmitted as a broadcast signal containing the plurality of indicators each being associated with an identifier identifying the user equipment to which it applies. Thus, user equipment that operate within this system require lattice encoders and also the ability to receive the broadcast signals and to identify the power indicator and to respond to this by transmitting the lattice encoded signal at the indicated power level.

A sixth aspect of the present invention provides a user equipment comprising: a receiver operable to receive a broadcast signal comprising a plurality of power indicators for a plurality of user equipment; control logic operable to identify said power indicator corresponding to said user equipment; a lattice code encoder operable to encode user equipment messages; a transmitter for transmitting said encoded user equipment message at a power indicated by said power indicator.

A seventh aspect of the present invention provides a computer program operable and executed by a computer to control said computer to perform a method according to a first aspect, a third aspect or a fifth aspect of the present invention.

A further aspect provides a network communication system comprising a plurality of network nodes according to a second aspect, a central control network node according to a fourth aspect and a plurality of user equipment according to a sixth aspect.

Further particular and preferred aspects are set out in the accompanying independent and dependent claims. Features of the dependent claims may be combined with features of the independent claims as appropriate, and in combinations other than those explicitly set out in the claims.

Where an apparatus feature is described as being operable to provide a function, it will be appreciated that this includes an apparatus feature which provides that function or which is adapted or configured to provide that function.

BRIEF DESCRIPTION OF THE DRAWINGS

Embodiments of the present invention will now be described further, with reference to the accompanying drawings, in which:

Figure 1 schematically illustrates a conventional wireless communication network with centralised processing of uplink signals;
Figure 2 shows a schematic illustration of a conventional joint processing coordinated multipoint (JP-CoMP) wireless network;
Figure 3 schematically shows a coordinated multiple point network according to an embodiment;
Figure 4 shows a flow diagram illustrating steps of a method performed at a base station according to an embodiment;
Figure 5 shows a flow diagram illustrating steps of a method performed at a user equipment according to an embodiment;
Figure 6 shows a flow diagram illustrating steps of a method performed at a central unit according to an embodiment;
Figure 7 shows a flow diagram illustrating steps of a method performed by a system according to an embodiment;
Figure 8 schematically shows the operation of a low density lattice code encoder; and
Figure 9 schematically shows a network comprising multiple base stations acting as a large-scale distributed antenna array according to an embodiment.

DESCRIPTION OF THE EMBODIMENTS

Before discussing the embodiments in any more detail, first an overview will be provided.

A capacity-increasing technique, for wireless uplink transmissions of 5G RAN with centralized processing, is proposed that seeks to achieve CoMP-like benefits without increasing the backhaul load compared to plain non-cooperative networks.

The technique takes advantage of the linear properties of lattice codes. It uses lattice coding at each user equipment and seeks to provide integer or near integer combinations of these signals when they are received at each base station, by in embodiments, using central control of the power transmission of each user equipment. The received signals are in some cases multiplied by scaling factors at the base stations prior to decoding to further reduce any fractional coefficients. The combined signal formed of multiple lattice encoded signals from multiple user equipment, is then sent through a lattice decoder which owing to the properties of lattice codes allows decoding not only of individual lattice codes but also of integer sums of lattice codes. Thus, the signal is decoded and the decoded signal corresponds to an integer sum of user equipment messages and this signal can then be transmitted to a central unit where the integer sums can be resolved using liner equations and the individual messages retrieved.

In this way a network communication system that provides cooperation between base stations and spectral efficiency of uplink traffic on the backhaul link to the central control unit and low processing requirements on individual base stations is provided.

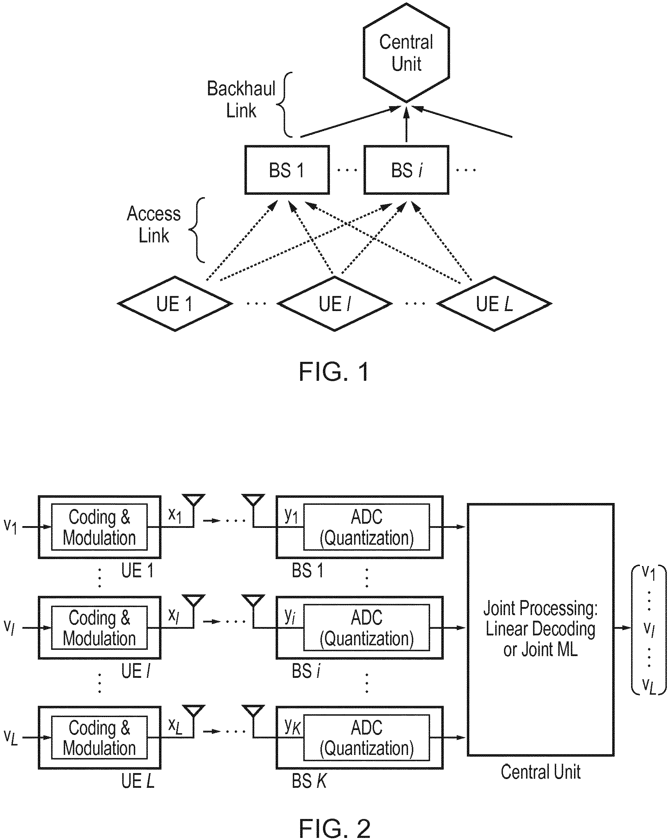

An appreciation of the problems addressed by the present technique may be gained by an analysis of the conventional systems shown in Figures 1 and 2. In this regard, an abstract model illustrating the transmission of uplink data in a 5G RAN (radio access network) with centralized processing is illustrated in Fig. 1. The base stations, BSs serve as intermediate points for data exchange between the central unit and the UEs. In the uplink, the messages from the UEs are forwarded to the central unit. The links connecting UEs and BSs, referred to as the access link, are wireless. The links connecting BSs and the central unit are referred to as the backhaul link. We assume the backhaul link has limited bandwidth. It may be implemented as a wireless or wireline link.

Since the received noisy signals at each BS are analogue, transmitting them to a central unit requires an excessively wide bandwidth. Hence this signal is quantized and converted to a (compressed) digital signal as shown in Figure 2. In the current CoMP solutions, each BS adopts a vector quantizer to transform the received noisy signals into digital signals. The quantized signals are then sent over the backhaul link to the central unit for further joint processing JP-CoMP (joint processing coordinated multi point). There are two major categories of JP-CoMP: one is linear processing, e.g., zero-forcing or MMSE (minimum means square error) equalization over all quantized signals; the other one is the joint ML (maximum likelihood) decoding over all quantized signals. The schematic illustration of the conventional JP-CoMP can be seen in Fig. 2, where $\mathbf{v}_\ell$ and $\mathbf{x}_\ell$, $\ell \in \{1,...,L\}$, denote the user data and the transmitted signal at UE $\ell$, respectively; $\mathbf{y}_\ell$, $i \in \{1,...,K\}$, denotes the received signal at BS $i$.

However, the drawbacks of the CoMP-JP are also clear:

1) The vector quantizer adopted at each BS introduces quantization errors which degrades the performance;
2) In order to reduce the quantization error, the vector quantizer has to use more bits, namely, a larger quantization codebook. This significantly increases the backhaul load which is a major disadvantage of these approaches and leads to significantly increased costs.

The joint processing is another dominant factor. However, the linear processing approach results in a poor error performance while the joint ML decoding requires an excessively high computation complexity, especially, when the numbers of UEs and BSs are large.

The above approach based on exhaustive signal detection is very demanding in terms of data backhaul. More specifically, suppose there are $K$ BSs serving $L$ UEs and each UE transmits with a rate up to $a$ bits/symbol. If $b$ -bit quantization is applied at each BS then the total backhaul load of a conventional JP-CoMP is equal to $abK$ bit/symbol, which will be excessively heavy especially when the numbers of BSs are large.

Embodiments of the present technique suggest a new approach to uplink CoMP, which addresses the main issues of existing techniques by

(1) resolving the problem of extremely high backhaul bandwidth requirements, and
(2) significantly reducing the computational complexity compared to existing solutions.

In particular, in embodiments it is proposed to

- use a low-density lattice code (LDLC) as a basis for a new waveform design i.e., data encoding and medium access;
- allow BS to decode the integer combinations of UE's codewords rather than separating them;
- cooperate BSs based on a designed power control algorithm with a relatively low computational complexity, which facilities BSs to round the received signals into the integer combinations of UEs' codewords;
- provide a single-input-single-output (SISO) LDLC decoder with linear complexity for each BS, which exploits the posterior probability of integer combinations, for extracting UEs' data.

The present technique seeks to exploit the linearity of lattice codes. Unlike two-dimensional constellation such as PSK (phase-shift keying) or QAM (quadrature amplitude modulation), the proposed L-CoMP adopts a multi-dimensional constellation, referred to as a lattice, derived from LDLC (low density lattice code). The LDLC has the following properties:

1) LDLC has a superior shaping gain over the conventional two two-dimensional constellation such as PSK or QAM;
2) LDLC is a group code whose linearity indicates that the combination of several lattice codes is a still a valid lattice code. This can be used to exploit the superposition of useful and interference signals.

In summary cooperation based on power control with low computational complexity is provided. In the proposed approach, the BS cooperation is controlled by the central unit which distributes the weighted vectors of the cooperation matrix to each BS, which are used to scale the received signals. The cooperation matrix is obtained by finding the optimal power allocation scheme which minimizes or at least reduces the co-channel interference. The purpose of power control is to facilitate rounding of the received superimposed signal at each BS to an integer combination of UEs' codewords such that the linearity of lattice codewords can be exploited. The BSs broadcast the optimal or preferred power factors to all UEs. As such, when each UE transmits with the allocated power, the rounding noise of the proposed approach is minimized or at least reduced. It is worth noting that the complexity of this cooperation is mainly raised by the rounding function over channels, which is excessively low.

An explanation of how power weighting factors and scaling factors can act to reduce the fractional coefficients of the user equipment codewords is provided below using a simplified scenario with two user equipment and ignoring the complex nature of the signals.

If one were to consider the combined encoded signal received at each base station as a simplified signal received from 2 user equipment, then for a hypothetical example a combined signal could be $y = 2.3x_1 + 1.4x_2 + n$ where $x_i$ is the encoded signal from each user equipment and n is noise. As the lattice codebook has codewords corresponding to integer combinations of other codewords there will be a codeword for $y = 2x_1 + 1x_2$ and one can consider there to be a noise coefficient of $n + 0.3x_1 + 0.4x_2$. Various methods can be used to reduce this noise for example weighting factors can be provided to the power output by the user equipment to increase or decrease the size of the fractional coefficient portion of the signal. Thus, for example if a weighting factor of 3 was provided to the first user equipment and one of 2 to the second user equipment then the signal would become $y = 6.9x_1 + 2.8x_2 + n$ and one could consider that to be the codeword $7x_1 + 3x_2$ with noise of $0.1x_1 + 0.2x_2 + n$. In this way by carefully considering co-channel interference and the coefficients of each user equipment signal received at the base station, a power factor for each user equipment can be derived which reduces noise at the decoder.

Noise related to the non-integer coefficients could be reduced further by use of a scaling factor. For the hypothetical example above one could use a factor of say 10, whereupon all of the factors for $x_1$ and $x_2$ become integers and

the noise simply becomes 10n. Thus, the central unit can analyse the strength of the signals received at each base station from each user equipment, and it can determine power weighting factors and scaling factors which will reduce the noise, where the noise includes the fractional portions of the coefficients of the codewords corresponding to the encoded user equipment messages received at the base station. It should be noted that in reality the signals x will be complex signals and as such the scaling factor will be a vector.

Decoding with low computational complexity is also provided. This is advantageous as this is provided at the base station which as the number of these increases is a significant overhead. In this regard, the proposed L-CoMP does not require the BS to distinguish each UE's codeword by using joint multiuser detection. Instead, the BS estimates the best integer combination of UEs' codewords. As this integer combination is also a valid codeword of LDLC, it can be directly fed into the designed LDLC decoder. Then the integer combinations of UE's messages can be obtained. The BS does not need to separate each UE's codeword any more, hence a single-in-single-out (SISO) decoder is sufficient.

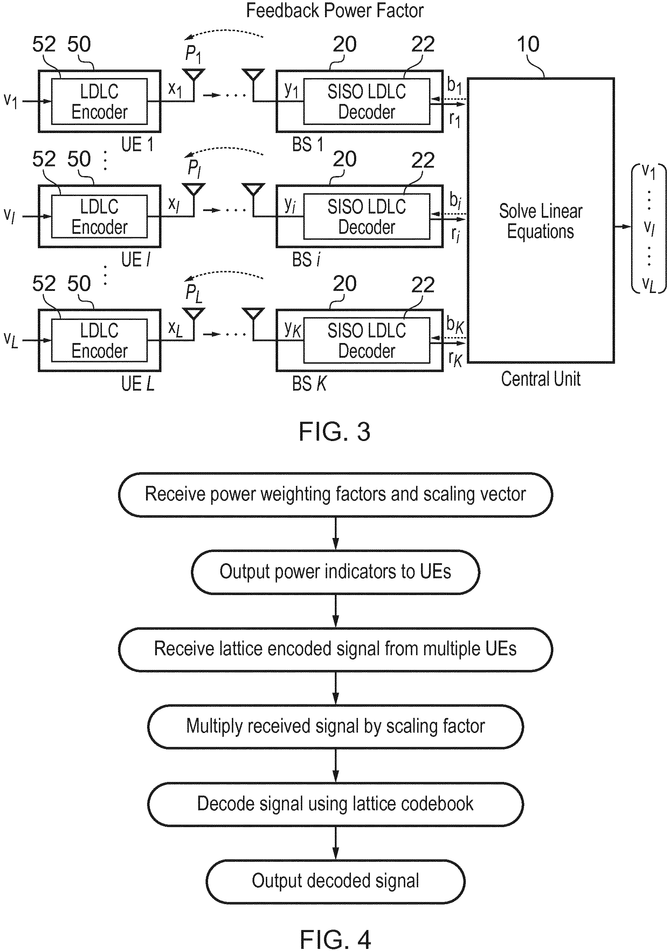

A schematic illustration of the proposed L-CoMP, can be seen in Fig. 3, where $\mathbf{v}_\ell$, $\mathbf{x}_\ell$ and $P_\ell$, $\ell \in \{1,...,L\}$, denote the user data, the lattice codeword, and the transmitting power, respectively; $\mathbf{y}_i$, $\mathbf{b}_i$ and $\mathbf{r}_i$, $i \in \{1,...,K\}$, denote the received signal, weighted vector of coordination matrix and decoded integer combination of user data, respectively.

In this figure a plurality of user equipment $UE_1$ (50) each having lattice encoders (52) receive input signals $v_l$ and encode them to form encoded user equipment messages or codewords $x_l$ which are transmitted and received at base stations BSi (20). Here signals from a plurality of user equipment combine to form a combined encoded signal $y_i$ which if the power of the UEs is chosen carefully is approximately an integer combination of the signals $x_l$. This combined signal may be further rounded by multiplication by a scale factor vector to further reduce any remaining fractional coefficients and the resultant is input to the decoder 22 as a serial stream. The decoder uses the same codebook as the encoders 52 and outputs a signal $r_k$ which is an integer sum of the signals received at the user equipment $v_l$. These signals are sent to central unit 10 where the linear equations that they represent are solved to generate the original messages $v_l$.

As can be seen from Figure 3 and as noted above, after passing through the SISO LDLC decoder (22), the resultant signal is the integer combination of UEs' data, which is then transmitted over the backhaul link. The superiority of the proposed L-CoMP over the conventional JP-CoMP is that as each BS does not need to decode all UEs' data, transmitting integer combinations of UEs' data reduces the backhaul load significantly. Suppose there are $K$ BSs serving $L$ UEs and each UE transmits with a rate up to $a$ bits/symbol. The total backhaul load of the proposed L-CoMP is then $aK$ bit/symbol while that of the conventional JP-CoMP with $b$ -bit quantization is $abK$ bit/symbol.

Figure 4 schematically illustrates a method performed at a base station according to an embodiment. The base station receives power weighting factors from the central unit, the power weighting factors relating to each of the plurality of user equipment within the cell of the base station. The base station outputs power indicators based on the power weighting factors to each of the user equipment. In some embodiments it does this by broadcasting a signal with indicators for all the user equipment, each indicator being associated with an identifier identifying the relevant user equipment. These power indicators will indicate to the user equipment the power that the user equipment should use when transmitting lattice encoded uplink messages. The base station will receive these lattice encoded messages from the multiple user equipment at an antenna as a combined signal consisting of the individual user equipment signals summed together. If the power indicators have been correctly selected, then the coefficients for each user equipment signal should be close to an integer. This combined encoded signal is multiplied by a scaling factor which takes the form of a vector as the signal is a complex signal. This scaling factor has been calculated to round the coefficients of the individual user equipment signals such that any fractional coefficient is further reduced. The combined encoded signal with substantially integer coefficients is then decoded using the same lattice codebook as was used to encode the individual user equipment messages and the decoded signal which corresponds to an integer combination of the original user equipment messages is output from the base station to a central unit. In this way, the base station does not need to identify the individual user equipment messages that are received but rather it decodes the combined message and outputs a combined decoded message, using the properties of the lattice code and scaling factors and power weightings to enable this decoding to be successfully performed. This not only reduces the processing requirement at the base station but it also reduces the bandwidth required to transmit this backhaul signal to the central unit.

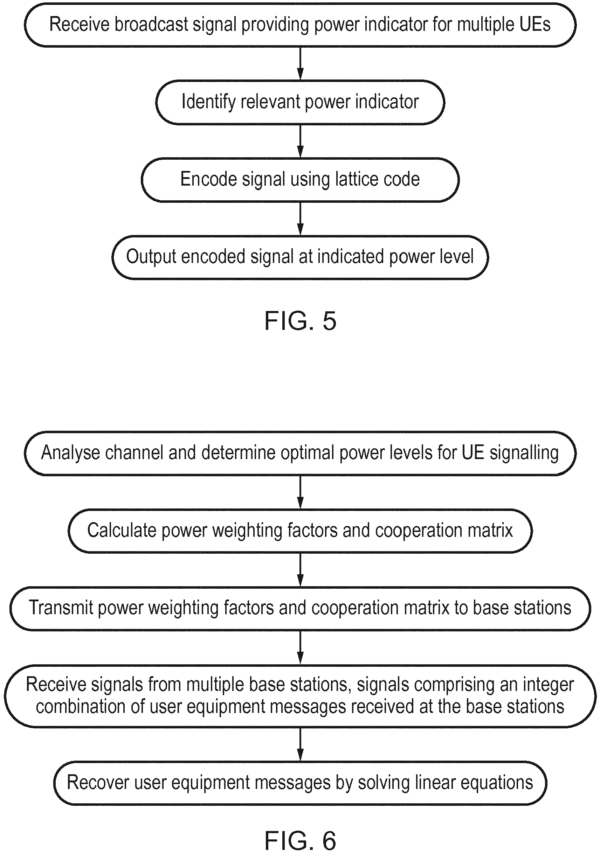

Figure 5 schematically illustrates steps performed at each user equipment according to an embodiment. The user equipment receives the broadcast signal from the base station which contains power indicators for the multiple user equipment that are served by the base station. The user equipment will identify the power indicator that is relevant to itself and it will encode any signal it receives from a user using a lattice encoder and will output this encoded signal at the power level indicated by the power indicator it received.

Figure 6 provides a flow diagram illustrating steps of a method performed at the central unit. The central unit analyses the channels on which the user equipment transmit and determines the optimal or at least preferred power levels for this user equipment signalling. In this way it determines power weighting factors for each user equipment and a cooperation matrix which provides the scaling vectors to the base stations. It transmits these power weighting factors and the cooperation matrix to the base station. The central unit also receives signals from the multiple base stations and these signals comprise an integer combination of user equipment messages that were received at the base stations. The central unit will recover the individual user equipment messages by solving the linear equations that these integer combinations of user equipment form.

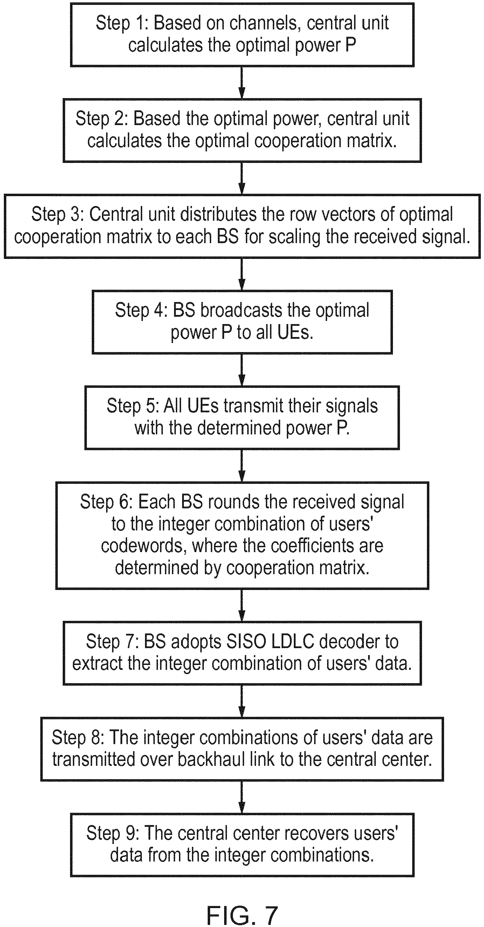

Figure 7 provides a flow diagram illustrating steps performed by the system according to an embodiment. Initially, a central unit calculates the optimal or preferred power for each user equipment based on its analysis of the channels that the user equipment transmit on. Then based on this determined optimal power, the central unit will calculate the optimal cooperation matrix.

The central unit then distributes the row vectors of the optimal cooperation matrix to each base station for scaling the received combined encoded signal prior to decoding. This scaling helps round the coefficients of the combined signal to form integers or near integers.

Each base station broadcasts transmission power indicators to the user equipment within its cell and the user equipment then transmit their uplink signals with the indicated power.

Each base station will, on receiving the combined encoded signal from multiple user equipment, round this signal to an integer combination or near integer combination of the user's codewords using the cooperation vector received from the central unit. The base station will then use a single input/single output LDLC decoder to extract the integer combination of user equipment data and output this integer combination of decoded user equipment data. This integer combination of user data is then transmitted over the backhaul link to the central unit where the central unit recovers the user data from the integer combinations by solving the linear equations.

The following text explains in more detail the above-mentioned three aspects of the proposed technique.

## Low density lattice codes

Let R denote the real field. An $n$ -dimensional lattice, denoted by $\Lambda$, is a set of points in R" such that if x, $\mathbf{y} \in \Lambda$, then $\mathbf{x} + \mathbf{y} \in \Lambda$ ; and if $\mathbf{x} \in \Lambda$, then $-\mathbf{x} \in \Lambda$. A lattice can always be written in terms of a lattice generator matrix $\mathbf{G} \in \mathrm{R}^{n \times n}$

$$\Lambda = \left\{ \mathbf{x} = \mathbf{G}\mathbf{v} : \mathbf{v} \in Z^{n} \right\}.$$

The low-density lattice code (LDLC) is constructed by extending the well-known low-density parity check codes (LDPC) - this can be done by extending the parity check matrix and syndrome matrix of LDPC from finite field to real or complex field. An $n$ dimensional LDLC is an $n$ -dimensional lattice code with a non-singular generator matrix G satisfying det|$\mathbf{G}$| =1, whose parity check matrix $\mathbf{W} = \mathbf{G}^{-1}$ is sparse.

The row or column degree of $\mathbf{W}$ is defined as the number of nonzero elements in row or column, respectively. A $n$ -dimensional LDLC is regular if all the row degrees and column degrees of the parity check matrix are equal to a common degree $d$ . A $n$ - dimensional regular LDLC with degree $d$ is called "Latin square LDLC" if every row and column of the parity check matrix has the same nonzero values, except for a possible change of order and random signs. The sorted sequence of these $d$ values will be referred to as the generating sequence of the Latin square LDLC.

Here is a simple example of the parity check matrix of a real LDLC with dimension $n$ = 6, row degree 4, column degree 3 and generating sequence {1,0.8,0.7,0.5},

$$\mathbf{W} = \begin{bmatrix} -0.8 & 0.7 & 0 & 0.5 & 0 & -1 \\ 0 & 0 & 1 & -0.5 & 1 & -0.8 \\ -0.5 & 1 & 0 & -0.8 & 0 & 0.5 \\ 1 & 0 & 0.8 & 0 & 0.5 & 0 \\ 0 & -0.5 & 0 & 1 & 0.8 & 0 \end{bmatrix}.$$

## Shaping for Transmit Power Constraint

In practice, shaping algorithms are adopted such that LDLC codewords can meet transmission power constraints. In embodiments, each UE adopts the *hypercube shaping*, based on a lower triangular parity-check matrix $\mathbf{w}$, to transfer the integer information vector $\mathbf{v}_\ell$ to another integer vector $\mathbf{v}'_\ell$ such that $\mathbf{x}'_\ell = \mathbf{G}\mathbf{v}'_\ell$ satisfies the power constraint. The hypercube shaping operation is given by

$$v'_{\ell,k} = v_{\ell,k} - Mr_{\ell,k},$$

where $r_{\ell,k}$ is calculated as

$$r_{\ell,k} = \left\lfloor \frac{1}{M} \left( v_{\ell,k} - \sum_{i=1}^{k-1} H_{k,i} x'_{\ell,i} \right) \right\rceil .$$

One can infer $\mathbf{x}'_\ell = \mathbf{x}_\ell \bmod \Lambda$ from $\mathbf{v}'_\ell = \mathbf{v}_\ell \bmod M$ due to the linearity of LDLC.

## User data transmission

During data transmission, binary data are grouped to represent integers, and then mapped onto $n$-dimensional codewords of the LDLC lattice.

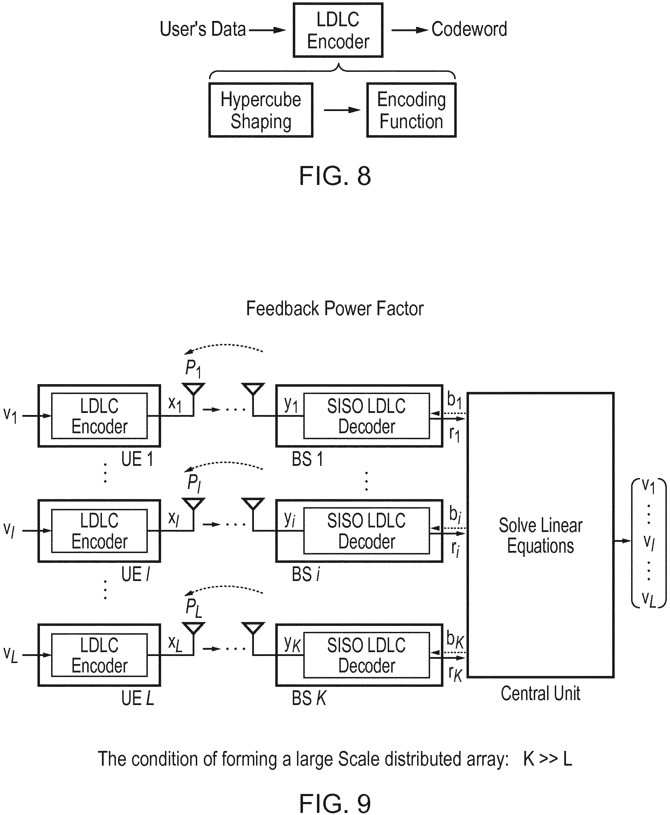

Individual dimensions of each codeword are then mapped to distinct OFDM subcarriers or single antenna element of MIMO system. The encoding procedure is shown in Figure 8.

## User data decoding

Reception of superimposed codeword

Suppose there are $K$ BSs serving $L$ UEs such that the superimposed signal at the BS $i$ can be virtually presented as

$$\mathbf{y}_i = \sum_{\ell=1}^{L} h_{i,\ell} \sqrt{P_\ell} \mathbf{x}_\ell + \mathbf{z}_i ,$$

where $\mathbf{x}_\ell$ is the transmitted lattice codeword of UE $\ell$ with dimension $n$ and power $P_\ell$; $h_{i,\ell}$ is the channel coefficient from UE $\ell$ to BS $i$; and $z_i \sim CN(0, \sigma^2 I^n)$, (where ~ denotes satisfies the distribution) is the noise.

Treating the whole system as a distributed MIMO system, the received signals at BSs can thus be represented as

$$\mathbf{Y} = \mathbf{HPX} + \mathbf{Z}$$

where $\mathbf{P} = \begin{bmatrix} \sqrt{P_1} & \cdots & 0 \\ \vdots & \ddots & \vdots \\ 0 & \cdots & \sqrt{P_L} \end{bmatrix}$ denotes the power matrix whose diagonal entries are the transmitting power of each UE.

In embodiments, the received signal $\mathbf{Y}$ is multiplied by a coordination matrix $\mathbf{C}$ for cooperating BSs, given by

$$\mathbf{CY} = \mathbf{CHPX} + \mathbf{CZ} .$$

The idea is to simply round the channel coefficients in order to form the integer combination of lattice codewords. Based on this idea, the above scaled signal can be expanded as

$$\mathbf{CY} = \mathbf{CHPX} + \mathbf{CZ}$$
$$= \lfloor \mathbf{CHP} \rceil \mathbf{X} + \underbrace{\left( \mathbf{CHP} - \lfloor \mathbf{CHP} \rceil \right) \mathbf{X} + \mathbf{CZ}}_{z_{\text{eff}}} ,$$

where $\lfloor \cdot \rceil$ denotes the element-wise rounding function and clearly, $\mathbf{CHP}$ - $\lfloor \mathbf{CHP} \rceil$ is the fraction part of $\mathbf{CHP}$ ; Let B~ $\lfloor \mathbf{CHP} \rceil$ denote the coefficient matrix of integer combinations; and $\mathbf{z}_{\text{eff}}$ denotes the overall effective noise with the following noise variance:

$$\sigma_{\text{eff}}^2 = \frac{1}{n}\mathrm{E}\left\|\left(\mathbf{CHP}-\lfloor\mathbf{CHP}\rceil\right)\mathbf{X}+\mathbf{CZ}\right\|^2$$
$$= \left\|\mathbf{CHP}-\lfloor\mathbf{CHP}\rceil\right\|^2 + \left\|\mathbf{C}\right\|^2 .$$

Let $\mathbf{y}_i^T$, $\mathbf{b}_i^T$, $\mathbf{c}_i^T$ and $\mathbf{z}_{i,\text{eff}}^T$ denote the row vectors on the $i$-th BS of **Y**, **B**, **C**, and $\mathbf{z}_{\text{eff}}$, respectively. Based on these, the received signal at BS can be re-expressed as

$$\mathbf{c}_i^T\mathbf{y}_i^T = \mathbf{b}_i^T\mathbf{X} + \underbrace{\left(\mathbf{c}_i^T\mathbf{HP}-\mathbf{b}_i^T\right)\mathbf{X}+\mathbf{c}_i^T\mathbf{Z}}_{\mathbf{z}_{i,\text{eff}}^T} ,$$

where $\mathbf{z}_{i,\text{eff}}^T$ denotes the effective noise at BS $i$ with the variance

$$\sigma_{i,\text{eff}}^2 = \frac{1}{n}\mathrm{E}\left\|\left(\mathbf{c}_i^T\mathbf{HP}-\mathbf{b}_i^T\right)\mathbf{X}+\mathbf{c}_i^T\mathbf{Z}\right\|^2$$
$$= \left\|\mathbf{c}_i^T\mathbf{HP}-\mathbf{b}_i^T\right\|^2 + \left\|\mathbf{c}_i^T\right\|^2 .$$

Expanding $\sigma_{i,\text{eff}}^2$, we have

$$\sigma_{i,\text{eff}}^2 = \mathbf{c}_i^T\mathbf{c}_i + \left(\mathbf{c}_i^T\mathbf{HP}-\mathbf{b}_i^T\right)^T\left(\mathbf{c}_i^T\mathbf{HP}-\mathbf{b}_i^T\right)$$
$$= \mathbf{c}_i^T\mathbf{c}_i + \left(\mathbf{c}_i^T\mathbf{HPH}^T\mathbf{P}^T\mathbf{c}_i - 2\mathbf{b}_i^T\mathbf{c}_i^T\mathbf{HP}+\mathbf{b}_i^T\mathbf{b}_i\right),$$
$$= \mathbf{c}_i^T\left(\mathbf{I}+\mathbf{HPH}^T\mathbf{P}^T\right)\mathbf{c}_i - 2\mathbf{b}_i^T\mathbf{c}_i^T\mathbf{HP}+\mathbf{b}_i^T\mathbf{b}_i$$

Let the derivative w.r.t. $\mathbf{c}_i$ be equal to zero:

$$\frac{d\sigma_{i,\text{eff}}^2}{d\mathbf{c}_i} = 2\left(\mathbf{I}+\mathbf{HPH}^T\mathbf{P}^T\right)\mathbf{c}_i - 2\mathbf{b}_i^T\mathbf{c}_i^T\mathbf{HP} = 0 ,$$

then we have:

$$\tilde{\mathbf{c}}_i = \mathbf{b}_i^T\mathbf{HP}\left(\mathbf{I}+\mathbf{HPH}^T\mathbf{P}^T\right)^{-1} .$$

As such, the optimal global coordination matrix **C** is given by

$$\tilde{\mathbf{C}}_i = \mathbf{BHP}\left(\mathbf{I}+\mathbf{HPH}^T\mathbf{P}^T\right)^{-1} .$$

<u>User Power Control</u>

As the total power is constrained, the proposed power control algorithm aims at minimizing the variance of the effective noise, given by

$$\tilde{\mathbf{P}} = \arg\min_{\mathbf{P}}\sigma_{\text{eff}}^2 = \arg\min_{\mathbf{P}}\left\{\left\|\left(\mathbf{CHP}-\lfloor\mathbf{CHP}\rceil\right)\right\|^2 + \left\|\mathbf{C}\right\|^2\right\} ,$$

$$\text{s.t.} \left\| \tilde{\mathbf{P}} \right\|^2 \le P_{\text{Sum}}, \text{rank}\left( \lfloor \mathbf{CHP} \rceil \right) \ge L$$

where $P_{\text{Sum}}$ is the power constraint.

The above problem can be solved by linear programming. After solving this problem, the BSs can broadcast $\tilde{\mathbf{P}}$ to all UEs such that the UE can transmit the signal with the determined power. As such, the actual received signals after scaling can be represented as

$$\mathbf{c}_i^T \tilde{\mathbf{y}}_i^T = \mathbf{b}_i^T \mathbf{X} + \underbrace{\left( \mathbf{c}_i^T \mathbf{H} \tilde{\mathbf{P}} - \mathbf{b}_i^T \right) \mathbf{X} + \mathbf{c}_i^T \mathbf{Z}}_{\mathbf{z}_{i,\text{eff}}^T} ,$$

where $t_i \sim b_i^T X$ denotes the desired integer combination that will be passed through the designed SISO LDLC decoder.

User data decoding

To decode the desired integer combination $\mathbf{t}_i$, the decoder of the proposed L-CoMP has to exploit the following distribution

$$f_{T_i[j] \mathbf{c}_i^T \tilde{\mathbf{y}}_i^T} \left( \mathbf{t}_i[j] \mid \mathbf{c}_i^T \tilde{\mathbf{y}}_i^T \right) \propto \sum_{\mathbf{l}} \delta\left( \mathbf{t}_i[j] - \mathbf{l}[j] \right) \cdot \exp\left( -\frac{d^2\left( \mathbf{l}, \mathbf{c}_i^T \tilde{\mathbf{y}}_i^T \right)}{2\sigma_{i,\text{eff}}^2} \right) ,$$

where $\mathbf{t}_i[j]$ is the $j$-th component of $\mathbf{t}_i$; $\mathbf{l}$ is the lattice codeword and $\mathbf{l}[j]$ is the $j$-th component of it; $d\left( \mathbf{l}, \mathbf{c}_i^T \tilde{\mathbf{y}}_i^T \right)$ denotes the Euclidean distance between $\mathbf{c}_i^T \tilde{\mathbf{y}}_i^T$ and $\mathbf{l}$.

One can expand $\mathbf{t}_i$ as follows

$$\mathbf{t}_i = \mathbf{b}_i^T \mathbf{X} = \mathbf{b}_i^T \left( \mathbf{G} \mathbf{V} \right) = \mathbf{G} \cdot \underbrace{\mathbf{b}_i^T \mathbf{V}}_{\mathbf{r}_i} ,$$

where $\mathbf{t}_i$ itself is a valid codeword of LDLC such that $\mathbf{r}_i$, which is the integer combination of UEs' messages, can be extracted after passing $\mathbf{t}_i$ through the SISO LDLC decoder, given by $\hat{\mathbf{r}}_i = \text{LDLCDecoder}(\alpha \mathbf{y})$, where $\hat{\mathbf{r}}_i$ is the estimated signal.

The decoder iteratively estimates $f_{\mathbf{T}_i[j] \mathbf{c}_i^T \tilde{\mathbf{y}}_i^T} \left( \mathbf{t}_i[j] \mid \mathbf{c}_i^T \tilde{\mathbf{y}}_i^T \right)$ by using Gallager's message passing algorithm over real or complex field. However, unlike LDPC, in embodiments, the message sent by the variable nodes are PDFs of the dimensional-wise component of $\mathbf{t}_i$ while the message sent by the check nodes are the periodic extensions of PDFs of dimensional-wise component of $\mathbf{t}_i$. Let $\mathbf{t}_i[1],...,\mathbf{t}_i[j],...,\mathbf{t}_i[n]$ and $\mathbf{c}_i[1],...,\mathbf{c}_i[j],...,\mathbf{c}_i[n]$ denote the variable nodes and check nodes, respectively. The designed SISO decoder for LDLC lattice combination $\mathbf{t}_i$ can be summarized as the following specially designed algorithm:

- Initialization: the variable node $\mathbf{t}_i[j]$ sends the message

$$f_j^{(0)}\left( t_i \right) = \frac{1}{\sqrt{2\sigma_{i,\text{eff}}^2}} \exp\left( -\frac{\left| \mathbf{c}_i^T \tilde{\mathbf{y}}_i^T[j] - \mathbf{t}_i[j] \right|^2}{2\sigma_{i,\text{eff}}^2} \right)$$

to all neighbouring check nodes.
- Basic iteration of check node message: each check node shares a different message with the neighbouring variable nodes. Suppose there are $m$ (equals the row degree of $\mathbf{w}$) variable nodes connected to the check node $\mathbf{c}_i[j]$, denoted by $\mathbf{t}_{i,\upsilon}[j], \upsilon \in \{1,...,m\}$. We have an appropriate check equation $\sum_{\upsilon=1}^{m} \eta_\tau \mathbf{t}_{i,\upsilon}[j] \in Z$, where z is the integer set and $\eta_\tau$

is the entry of **W**. The message sent from $\mathbf{t}_{i,\upsilon}$ [*j*] to the check node $\mathbf{c}_i$ [*j*] in the previous half-iteration is denoted as $f_\upsilon(t_i)$, $\upsilon \in \{1,...,m\}$. The calculation of the message that the check node $\mathbf{c}_i$[*j*] sends back to the variable node $\mathbf{t}_{i,\tau}$ [*j*] follows the three basic steps:

- 1) The convolution step: all messages excluding $f_\upsilon(t_i)$ are convolved, where $\dfrac{t_i}{\eta_\upsilon}$ will be substituted into $f_\upsilon(t_i)$, $\upsilon \in \{1,...,m\} / \{\tau\}$:

$$\tilde{p}_\tau(t_i) = f_1\left(\frac{t_i}{\eta_1}\right) * \cdots * f_{\tau-1}\left(\frac{t_i}{\eta_{\tau-1}}\right) * f_{\tau+1}\left(\frac{t_i}{\eta_{\tau+1}}\right) * \cdots * f_m\left(\frac{t_i}{\eta_m}\right).$$

- 2) The stretching step: $\tilde{p}_\tau(t_i)$ is stretched by $-\eta_\tau$ $\tilde{p}_\tau(t_i) = \tilde{p}_\tau(-\eta_\tau t_i)$.

- 3) The periodic extension step: $p_\tau(t_i)$ is extended to a periodic function with period $\dfrac{1}{|\eta_\tau|}$ given by

$$P_\tau(t_i) = \sum_{\omega=-\infty}^{\infty} p_\tau\left(t_i - \frac{\omega}{\eta_\tau}\right),$$

where $P_\tau(t_i)$ is the final message sent to the variable node $t_{i,\tau}$[*j*].

- Basic iteration of variable node message: each variable node sends a message to the neighbouring check node.
- Suppose there are *e* (equals to the column degree of **w**) check nodes connected to the variable node $\mathbf{t}_i$[*j*], which are denoted by $\mathbf{c}_{i,\lambda}$[*j*],$\lambda \in \{1,...,e\}$. The message sent back to the variable node $\mathbf{t}_i$[*j*] by the check node $\mathbf{c}_{i,\lambda}$[*j*] in the previous half-iteration is denoted by $P_\lambda(t_i)$. The calculation of the message sent from the variable node $\mathbf{t}_i$ [*j*] to the check node $\mathbf{c}_{i,\tau}$[*j*] follows the two basic steps:

- 1) The product step

$$\tilde{f}_\tau(t_i) = e^{-\frac{\left(\mathbf{c}_i^T \tilde{\mathbf{y}}_i^T[j] - t_i\right)^2}{2\sigma_{i,\text{eff}}^2}} \prod_{\substack{\lambda=1 \\ \lambda \neq \tau}}^{e} P_\lambda(t_i).$$

- 2) The normalization step

$$f_\tau(t_i) = \frac{\tilde{f}_\tau(t_i)}{\int_{-\infty}^{\infty} \tilde{f}_\tau(t_i)\,dt_i}.$$

The basis iteration is repeated until the iteration threshold is achieved.

- Final Decision: To extract the desired integer combination of UEs' message, $\mathbf{r}_i$, the final PDF of the codeword elements $\mathbf{t}_i$[1],...,$\mathbf{t}_i$[*j*],...,$\mathbf{t}_i$[*n*] should be estimated in the final iteration without excluding any check node message in the product step, given by

$$\tilde{f}_{j,\text{final}}(t_i) = e^{-\frac{\left(\mathbf{c}_i^T \tilde{\mathbf{y}}_i^T[j] - t_i\right)^2}{2\sigma_{i,\text{eff}}^2}} \prod_{\lambda=1}^{e} P_\lambda(t_i).$$

Then, the estimated codeword element can be obtained from

$\overset{\cdot}{0}$ At last, the desired $\mathbf{r}_i$ can be calculated as $\hat{\mathbf{r}}_i = \lfloor \mathbf{W} \cdot \mathbf{t}_i \rceil$.

Backhaul Transmission and User Data Recover

These $K$ integer combinations $\hat{\mathbf{r}}_i$ are transmitted over the backhaul link to the central unit. We realize that the backhaul load of transmitting $K$ integer combination $\hat{\mathbf{r}}_i$'s is much less that of JP-CoMP.

The coefficients of these integer combinations form a matrix $\mathbf{B}$. In order to recover the UEs' messages $[\mathbf{v}_1,...,\mathbf{v}_L]$, the rank of $\mathbf{B}$ should be no less than $L$. As such, BS can take the pseudo inverse to recover $[\mathbf{v}_1,..., \mathbf{v}_L]$, given by

$$\begin{bmatrix} \hat{\mathbf{v}}_1 \\ \vdots \\ \hat{\mathbf{v}}_L \end{bmatrix} = \left(\mathbf{B}^T \mathbf{B}\right)^{-1} \mathbf{B}^T \cdot \begin{bmatrix} \hat{\mathbf{r}}_1 \\ \vdots \\ \hat{\mathbf{r}}_K \end{bmatrix}.$$

where $[\hat{\mathbf{v}}_1,...,\hat{\mathbf{v}}_L]$ is the decoded users' data.

In summary, the present technique proposes a novel 5G radio access technology and waveform referred to as L-CoMP using advanced lattice coding techniques. In particular, a multidimensional lattice constellation is used for encoding UE data. The lattice constellation is constructed by the low density lattice codes (LDLC). Since all UEs use the same lattice codebook, the received integer combination of multiple codewords is also an element of the employed lattice codebook. Thus, each BS only needs to decode the integer combinations of UEs' LDLC codewords rather than separating them as required by the conventional CoMP. This paradigm significantly reduces the backhaul load because transmitting the integer combinations requires less bits compared with transmitting all UEs' codewords. The technique provides a scalable solution for cooperating the BSs based on the designed power control algorithm with a relatively low computational complexity. That is, finding the optimal transmit power in terms of minimizing or at least reducing the interference for each UE, such that after passing through the channels, the multiuser superimposed signal can be rounded into an integer combination of UEs' codewords. A designed single-input-single-output (SISO) LDLC decoder is adopted by each BS, which provides a linear decoding complexity even when the number of UEs is large.

Furthermore, the properties of the lattice codes are such that the technique is entirely scalable, so that there is no theoretical limit to the number of base stations that can operate in a system using this technique. This makes it appropriate for use in massive MIMO or large distributed antenna array systems, in which each base station acts as an antenna. In effect the algorithms used are applicable to any number of base stations and increasing the number of base stations compared to the number of user equipment will not affect the user messages that can be retrieved using the same algorithms. Figure 9 shows such a system. This system is analogous to that of Figure 3, and acts as a large scale distributed antenna array when the number of base stations is significantly greater than the number of user equipment.

In the example of Figure 9 where K is the number of base stations and L the number of user equipment, and K >> L, then K integer combinations (one for each base station) of the user equipment decoded messages are transmitted over the backhaul link to the central unit where a matrix B of the coefficients of these integer combinations are formed. Where the number of base stations K is greater than the number of user equipment L matrix B becomes elongate, however, this does not impede the retrieval of the pseudo inverse of this matrix and thus, the user equipment messages. This property of the technique enables it to be used in a large scale distributed antenna array or massive MIMO where each base station acts as an antenna within the array. An increase in the number of base stations has the advantage of allowing user equipment to operate at lower power.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

The functions of the various elements shown in the Figures, including any functional blocks labelled as "processors" or "logic", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions.

Moreover, all statements herein reciting principles, aspects, and embodiments of the invention, as well as specific examples thereof, are intended to encompass equivalents thereof.

**Claims**

1. A method performed at a network node configured to operate in a coordinated multiple network node system, comprising:

   receiving a combined encoded signal, said combined encoded signal comprising a combination of a plurality of encoded user equipment messages, each user equipment message being transmitted from a respective one of a plurality of user equipment and each being encoded using a lattice code to form codewords from a same codebook;
   decoding said combined encoded signal using said same codebook to generate a decoded combined signal; and
   outputting said decoded combined signal.

2. A method according to claim 1, wherein said lattice code comprises a low density lattice code.

3. A method according to any preceding claim, comprising a further step of:

   receiving a plurality of power weighting factors corresponding to said plurality of user equipment; and
   transmitting to each of said user equipment, an indicator of transmission power to be used by said user equipment when transmitting signals towards said network node, said indicator of transmission power being based on said received power weighting factors.

4. A method according to any preceding claim, comprising receiving a scaling factor vector and performing a further step of rounding said combined encoded signal prior to decoding by multiplying said combined encoded signal by said scaling factor vector.

5. A method according to any preceding claim, wherein said plurality of encoded user equipment messages are received at an antenna, and said combined encoded signal comprises a sum of said plurality of encoded user equipment messages.

6. A method according to any preceding claim wherein said decoder comprises a serial decoder operable to decode a serial input stream to form a serial output stream.

7. A network node configured to operate in a coordinated multiple network node system, said network node comprising:

   an antenna configured to receive encoded user equipment messages from a plurality of user equipment each of said plurality of user equipment messages being encoded using a same lattice code with a same codebook, and to output a combined encoded signal, comprising a combination of said plurality of encoded user equipment messages;

decoding logic operable to decode said combined encoded signal using said same codebook and to output a combined decoded signal to a port for connection to a backhaul link.

**8.** A method performed at a central network control node, said method comprising:

receiving a combined decoded signal from each of a plurality of network nodes, each of said plurality of received combined decoded signals comprising an integer combination of a plurality of user equipment messages received at said respective network node from a plurality of user equipment; and
solving a set of linear equations formed by said integer combination of user equipment messages to determine each user equipment message.

**9.** A method according to claim 8, comprising a further step of:

generating a plurality of power weighting factors for transmission to each of said plurality of network nodes, each of said plurality of network nodes receiving signals from said plurality of user equipment, and each of said plurality of power weighting factors being indicative of a transmission power to be used by a respective one of said plurality of user equipment; wherein
said power weighting factors are generated following analysis of said user equipment and network nodes and are selected to reduce co-channel interference between user equipment.

**10.** A method according to claim 9, wherein said power weighting factors are selected to seek to provide an integer combination of user equipment messages in a combined encoded user equipment signal received at each network node by reducing fractional coefficients of encoded user equipment messages in said combined encoded signal.

**11.** A method according to any one of claims 8 to 10, comprising generating a coordination matrix comprising a plurality of scaling factor vectors corresponding to said plurality of network nodes, said scaling factor vectors comprising scaling factors to reduce noise in a combined encoded signal received at each network node from a plurality of user equipment by rounding coefficients of encoded user equipment messages and thereby reducing a fractional portion of said coefficients in said combined encoded signal.

**12.** A central network control node comprising:

a receiver operable to receive a combined decoded signal from each of a plurality of network nodes, each of said plurality of received combined decoded signals comprising an integer combination of a plurality of user equipment messages, said method comprising:

solving a set of linear equations formed by said integer combination of user equipment messages to determine each user equipment message

**13.** A method performed at a user equipment comprising:

receiving a broadcast signal comprising a plurality of power indicators for a plurality of user equipment;
identifying said power indicator corresponding to said user equipment;
encoding a user equipment message using a lattice encoder;
transmitting said encoded user equipment message at a power indicated by said power indicator.

**14.** A user equipment comprising:

a receiver operable to receive a broadcast signal comprising a plurality of power indicators for a plurality of user equipment;
control logic operable to identify said power indicator corresponding to said user equipment;
a lattice code encoder operable to encode user equipment messages;
a transmitter for transmitting said encoded user equipment message at a power indicated by said power indicator.

**15.** A computer program operable when executed by a computer to control said computer to perform a method according to any one of claims 1 to 6, 8 to 11 and 13.

**Amended claims in accordance with Rule 137(2) EPC.**

**1.** A method performed at a network node configured to operate in a coordinated multiple network node system, comprising:

receiving a plurality of power weighting factors corresponding to a plurality of user equipment; and
transmitting to each of said user equipment, an indicator of transmission power to be used by said user equipment when transmitting signals towards said network node, said indicator of transmission power being based on said received power weighting factors;
receiving a combined encoded signal, said combined encoded signal comprising a combination of a plurality of encoded user equipment messages, each user equipment message being transmitted from a respective one of said plurality of user equipment and each being encoded using a lattice code to form codewords from a same codebook;
decoding said combined encoded signal using said same codebook to generate a decoded combined signal; and
outputting said decoded combined signal.

**2.** A method according to claim 1, wherein said lattice code comprises a low density lattice code.

**3.** A method according to any preceding claim, wherein said combined encoded signal is a complex signal, said method omprising receiving a scaling factor vector and performing a further step af rounding said combined encoded complex signal prior to decoding by multiplying said combined encoded signal by said scaling factor vector.

**4.** A method according to any preceding claim, wherein said, plurality of encoded user equipment messages are received at an antenna, and said combined encoded signal comprises a sum of said plurality of encoded user equipment messages.

**5.** A method according to any preceding claim wherein said decoder comprises a serial decoder operable to decode a serial input stream to form a serial output stream.

**6.** A network node (20) configured to operate in a coordinated multiple network node system, said network node comprising::

a receiver operable to receive a plurality of power weighting factors corresponding to a plurality of user equipment (50); and
a transmitter operable to transmit to each of said user equipment, an indicator of transmission power to be used by said user equipment when transmitting signals towards said network node, said indicator of transmission power being based on said received power weighting factors;
an antenna configured to receive encoded user equipment messages from said plurality of user equipment each of said plurality of user equipment messages being encoded using a same lattice code with a same codebook, and to output a combined encoded signal, comprising a combination of said plurality of encoded user equipment messages;
decoding logic (22) operable to decode said combined encoded signal using said same codebook and to output a combined decoded signal to a port for connection to a backhaul link.

**7.** A method performed at a central network control node (10), said method comprising:

generating a plurality of power weighting factors for transmission to each of a plurality of network nodes (20), each of said plurality of network nodes (20) receiving signals from a plurality of user equipment (50), and each of said plurality of power weighting factors being indicative of a transmission power to be used by a respective one of said plurality of user equipment (50); wherein
said power weighting factors are generated following analysis of said user equipment and network nodes and are selected to reduce co-channel interference between user equipment;
receiving a combined decoded signal from each of said plurality of network nodes, each of said plurality of received combined decoded signals comprising an integer combination of a plurality of user equipment messages received at said respective network node from a plurality of user equipment; and
solving a set of linear equations formed by said integer combination of user equipment messages to determine each user equipment message.

8. A method according to claim 7, wherein said power weighting factors are selected to seek to provide an integer combination of user equipment messages in a combined encoded user equipment signal received at each network node by reducing fractional coefficients of encoded user equipment messages in said combined encoded signal.

9. A method according to claim 7 or 8, comprising generating a coordination matrix comprising a plurality of scaling factor vectors corresponding to said plurality of network nodes, said scaling factor vectors comprising scaling factors to reduce noise in a combined encoded complex signal received at each network node (20) from a plurality of user equipment (50) by rounding coefficients of encoded user equipment messages and thereby reducing a fractional portion of said coefficients in said combined encoded signal.

10. A central network control node (10) comprising:

    a power weighting factor generator for generating a plurality of power weighting factors for transmission to each of a plurality of network nodes (20), each of said plurality of network nodes (20) receiving signals from a plurality of user equipment (50), and each of said plurality of power weighting factors being indicative of a transmission power to be used by a respective one of said plurality of user equipment (50); wherein said power weighting factors are generated following analysis of said user equipment and network nodes and are selected to reduce co-channel interference between user equipment;
    a receiver operable to receive a combined decoded signal from each or a plurality of network nodes, each of' said plurality of received. combined decoded signals comprising an integer combination of a plurality of user equipment messages and logic operable to solve a set of linear equations formed by said. integer combination of user equipment messages to determine each user equipment message.

11. A method performed at a user equipment (50) comprising:

    receiving a broadcast signal comprising a plurality of power indicators for a plurality of user equipment;
    identifying said power indicator corresponding to said user equipment;
    encoding a user equipment message using a lattice encoder;
    transmitting said encoded user equipment message at a power indicated by said power indicator.

12. A user equipment (50) comprising:

    a receiver operable to receive a broadcast signal comprising a plurality of power indicators for a plurality of user equipment;
    control logic operable to identify said power indicator corresponding to said user equipment;
    a lattice code encoder (52) operable to encode user equipment messages;
    a transmitter for transmitting said encoded user equipment message at a power indicated by said power indicator.

13. A computer program operable when executed by a computer to control said computer to perform a method according to any one of claims 1 to 5, 7 to 9 and 11.

FIG. 1

FIG. 2

Feedback Power Factor

FIG. 3

FIG. 4

Receive broadcast signal providing power indicator for multiple UEs

↓

Identify relevant power indicator

↓

Encode signal using lattice code

↓

Output encoded signal at indicated power level

## FIG. 5

Analyse channel and determine optimal power levels for UE signalling

↓

Calculate power weighting factors and cooperation matrix

↓

Transmit power weighting factors and cooperation matrix to base stations

↓

Receive signals from multiple base stations, signals comprising an integer combination of user equipment messages received at the base stations

↓

Recover user equipment messages by solving linear equations

## FIG. 6

Step 1: Based on channels, central unit calculates the optimal power P

Step 2: Based the optimal power, central unit calculates the optimal cooperation matrix.

Step 3: Central unit distributes the row vectors of optimal cooperation matrix to each BS for scaling the received signal.

Step 4: BS broadcasts the optimal power P to all UEs.

Step 5: All UEs transmit their signals with the determined power P.

Step 6: Each BS rounds the received signal to the integer combination of users' codewords, where the coefficients are determined by cooperation matrix.

Step 7: BS adopts SISO LDLC decoder to extract the integer combination of users' data.

Step 8: The integer combinations of users' data are transmitted over backhaul link to the central center.

Step 9: The central center recovers users' data from the integer combinations.

FIG. 7

User's Data → | LDLC Encoder | → Codeword

| Hypercube Shaping | → | Encoding Function |

## FIG. 8

Feedback Power Factor

$v_1$ → | LDLC Encoder | $x_1$ ...  $y_1$ | SISO LDLC Decoder | $b_1$ / $r_1$

UE 1   BS 1

$v_l$ → | LDLC Encoder | $x_l$ ... $y_i$ | SISO LDLC Decoder | $b_i$ / $r_i$

UE $l$   BS $i$

$v_L$ → | LDLC Encoder | $x_L$ ... $y_K$ | SISO LDLC Decoder | $b_K$ / $r_K$

UE $L$   BS $K$

$P_1$   $P_l$   $P_L$

Solve Linear Equations   Central Unit

$\begin{pmatrix} v_1 \\ \vdots \\ v_l \\ \vdots \\ v_L \end{pmatrix}$

The condition of forming a large Scale distributed array:   K >> L

## FIG. 9

Europäisches
Patentamt

European
Patent Office

Office européen
des brevets

# EUROPEAN SEARCH REPORT

Application Number

EP 15 30 6703

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DAVID GESBERT ET AL: "Multi-Cell MIMO Cooperative Networks: A New Look at Interference", IEEE JOURNAL ON SELECTED AREAS IN COMMUNICATIONS, IEEE SERVICE CENTER, PISCATAWAY, US, vol. 28, no. 9, 1 December 2010 (2010-12-01), pages 1380-1408, XP011336909, ISSN: 0733-8716, DOI: 10.1109/JSAC.2010.101202 | 1,3,5-9, 12,15 | INV. H04B7/02 ADD. H04W52/14 H04W52/38 H04W52/40 |
| Y | * abstract * | 2,13,14 | |
| A | * figures 1,4 * * section 3) Limited Backhaul to the CP; paragraph [1387] * * section 1) Coordinated power control; paragraph [1393] * | 4,10,11 | |
| Y | CHEN BIN ET AL: "Cooperative relaying with low-density lattice coding and joint iterative decoding", 2014 8TH INTERNATIONAL SYMPOSIUM ON TURBO CODES AND ITERATIVE INFORMATION PROCESSING (ISTC), IEEE, 18 August 2014 (2014-08-18), pages 254-258, XP032682442, DOI: 10.1109/ISTC.2014.6955124 [retrieved on 2014-11-12] | 2 | |
| A | * abstract * * chapter I. Introduction; figure 1 * | 1,3-15 | |
| Y | EP 2 252 117 A1 (CHINA MOBILE COMM CORP [CN]) 17 November 2010 (2010-11-17) | 13,14 | |
| A | * paragraph [0056] * | 1-12,15 | |

-/--

TECHNICAL FIELDS
SEARCHED        (IPC)

H04B
H04W

The present search report has been drawn up for all claims

| Place of search | Date of completion of the search | Examiner |
|---|---|---|
| Munich | 14 March 2016 | Sieben, Stefan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

Europäisches
Patentamt

European
Patent Office

Office européen
des brevets

# EUROPEAN SEARCH REPORT

Application Number

EP 15 30 6703

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SANDEROVICH A ET AL: "Structured superposition for backhaul constrained cellular uplink", INFORMATION THEORY, 2009. ISIT 2009. IEEE INTERNATIONAL SYMPOSIUM ON, IEEE, PISCATAWAY, NJ, USA, 28 June 2009 (2009-06-28), pages 1530-1534, XP031513562, ISBN: 978-1-4244-4312-3 | 1,2,4-8, 11-15 | |
| Y | * the whole document * | 3,9,10 | |
| Y | US 2015/173023 A1 (WALLERIUS ROGER [SE] ET AL) 18 June 2015 (2015-06-18) * paragraph [0001]; figures 7-9 * | 3,9,10 | |

TECHNICAL FIELDS
SEARCHED      (IPC)

The present search report has been drawn up for all claims

| Place of search | Date of completion of the search | Examiner |
|---|---|---|
| Munich | 14 March 2016 | Sieben, Stefan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

    .......................................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 15 30 6703

This annex lists the patent family members relating to the patent documents cited in the above-mentioned European search report.
The members are as contained in the European Patent Office EDP file on
The European Patent Office is in no way liable for these particulars which are merely given for the purpose of information.

14-03-2016

| Patent document cited in search report | | | Publication date | Patent family member(s) | | | Publication date |
|---|---|---|---|---|---|---|---|
| EP 2252117 | A1 | | 17-11-2010 | CN | 101557246 | A | 14-10-2009 |
| | | | | EP | 2252117 | A1 | 17-11-2010 |
| | | | | JP | 2011520314 | A | 14-07-2011 |
| | | | | KR | 20110018303 | A | 23-02-2011 |
| | | | | US | 2011032813 | A1 | 10-02-2011 |
| | | | | WO | 2009124459 | A1 | 15-10-2009 |
| US 2015173023 | A1 | | 18-06-2015 | EP | 2853120 | A1 | 01-04-2015 |
| | | | | US | 2015173023 | A1 | 18-06-2015 |
| | | | | WO | 2013174426 | A1 | 28-11-2013 |

EPO FORM P0459

For more details about this annex : see Official Journal of the European Patent Office, No. 12/82